(19) Europäisches Patentamt
European Patent Office
Office européen des brevets

(11) **EP 4 764 516 A1**

(12) **EUROPEAN PATENT APPLICATION**

(43) Date of publication:
**24.06.2026 Bulletin 2026/26**

(21) Application number: **25206404.3**

(22) Date of filing: **02.10.2025**

(51) International Patent Classification (IPC):
***G01R 31/26*** (2020.01)

(52) Cooperative Patent Classification (CPC):
**G01R 31/2621**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **23.12.2024 KR 20240193543**

(71) Applicant: **Korea University Research and Business Foundation, Sejong Campus Sejong-si 30019 (KR)**

(72) Inventors:
• **LEE, Jae Woo**
**30019 Sejong-si (KR)**
• **KIM, Sang Hyeok**
**30019 Sejong-si (KR)**
• **KIM, Donghyun**
**30019 Sejong-si (KR)**
• **YOON, Inkyu**
**30019 Sejong-si (KR)**
• **LEE, Somi**
**30019 Sejong-si (KR)**

(74) Representative: **V.O.**
**P.O. Box 87930**
**2508 DH Den Haag (NL)**

(54) **METHOD AND DEVICE FOR ANALYZING ELECTRICAL CHARACTERISTICS OF VERTICAL SIDEWALLS IN THREE-DIMENSIONAL SEMICONDUCTOR GATE STACK STRUCTURES**

(57) Disclosed is an analysis method and device for evaluating an electrical characteristic for a vertical sidewall in a semiconductor gate stack structure in a three-dimensional (3D) structure, which may be configured to prepare a plurality of 3D semiconductor gate stack structures having different areas, and including the same vertical sidewall within the areas, respectively, to measure electrical characteristics of the 3D semiconductor gate stack structures, respectively, and to detect an electrical characteristic of the vertical sidewall from relationship between the areas and the electrical characteristics through extrapolation.

FIG. 4

```
                    ┌─────────┐
                    │  Start  │
                    └────┬────┘
                         │
   ┌─────────────────────┴──────────────────────┐
   │ Prepare plurality of 3D semiconductor gate  │
   │ stack structures having different areas,    │──── 410
   │ and including the same vertical sidewall    │
   │ within areas, respectively                  │
   └─────────────────────┬──────────────────────┘
                         │
   ┌─────────────────────┴──────────────────────┐
   │ Measure electrical characteristics of 3D    │
   │ semiconductor gate stack structures,        │──── 420
   │ respectively                                │
   └─────────────────────┬──────────────────────┘
                         │
   ┌─────────────────────┴──────────────────────┐
   │ Detect electrical characteristic of         │
   │ vertical sidewall from relationship         │──── 430
   │ between areas and electrical                │
   │ characteristics through extrapolation       │
   └─────────────────────┬──────────────────────┘
                         │
                    ┌────┴────┐
                    │   End   │
                    └─────────┘
```

**Description**

BACKGROUND

1. Field of the Invention

Example embodiments of the present disclosure relate to technology for analyzing electrical characteristics of a memory device, and more particularly, to an analysis method and device for evaluating electrical characteristics of vertical sidewalls in a three-dimensional (3D) semiconductor gate stack structure. This patent was supported by the NRF(RS-2023-00280841).

2. Description of the Related Art

In a three-dimensional (3D) gate stack structure of a memory device, various physical structures, such as vertical sidewalls, planar areas, and edges, have complex impact on electrical characteristics. As a semiconductor device becomes smaller, the influence of vertical sidewalls increases, but it is difficult to individually measure the influence.

SUMMARY

The present disclosure proposes a technique for analyzing electrical characteristics of the entire area of a three-dimensional (3D) semiconductor gate stack structure and isolating only characteristics of vertical sidewalls through extrapolation. Through this, it is possible to accurately verify characteristics of vertical sidewalls and to optimize a gate insulating film and structure, thereby improving device performance and reliability.

The present disclosure provides an analysis method and device for evaluating an electrical characteristic of a vertical sidewall in a three-dimensional (3D) semiconductor gate stack structure.

Herein, an operating method of a computing device may include preparing a plurality of 3D semiconductor gate stack structures having different areas, and including the same vertical sidewall within the areas, respectively; measuring electrical characteristics of the 3D semiconductor gate stack structures, respectively; and detecting an electrical characteristic of the vertical sidewall from relationship between the areas and the electrical characteristics through extrapolation.

Herein, a computing device may include a memory, and a processor configured to connect to the memory, and to execute at least one instruction stored in the memory, and the processor may be configured to prepare a plurality of 3D semiconductor gate stack structures having different areas, and including the same vertical sidewall within the areas, respectively, to measure electrical characteristics of the 3D semiconductor gate stack structures, respectively, and to detect an electrical characteristic of the vertical sidewall from relationship between the areas and the electrical characteristics through extrapolation.

According to the present disclosure, for a compact 3D semiconductor gate stack structure, it is possible to precisely detect an electrical characteristic of only a vertical sidewall. Therefore, the electrical characteristic of the vertical sidewall may be utilized for optimization of a semiconductor device that is implemented in the 3D semiconductor gate stack structure. Specifically, it is possible to accurately verify a change in leakage current and effective oxide thickness (EOT) in the vertical sidewall, and to derive an optimal gate insulating film with a stable electrical characteristic. This may present a semiconductor device with improved capacitive effective thickness (CET), and the overall performance and reliability of the semiconductor device may be improved.

BRIEF DESCRIPTION OF THE DRAWINGS

These and/or other aspects, features, and advantages of the invention will become apparent and more readily appreciated from the following description of embodiments, taken in conjunction with the accompanying drawings of which:

FIG. 1 is a cross-sectional view illustrating a three-dimensional (3D) semiconductor gate stack structure to which various example embodiments are applied;
FIG. 2 is a diagram schematically illustrating a computing device according to various example embodiments;
FIG. 3 is a drawing for exemplarily explaining operational characteristics of a processor of FIG. 2;
FIG. 4 is a flowchart schematically illustrating an operating method of a computing device according to various example embodiments;
FIG. 5 is a flowchart illustrating an operation of detecting electrical characteristics of sidewalls of FIG. 4 in detail; and
FIG. 6 is a drawing for exemplarily explaining an operation of detecting electrical characteristics of sidewalls of FIG. 4.

DETAILED DESCRIPTION

Hereinafter, the present disclosure provides an analysis method and device for evaluating an electrical characteristic of a vertical sidewall in a three-dimensional (3D) semiconductor gate stack structure.

Hereinafter, various example embodiments will be described with reference to the accompanying drawings.

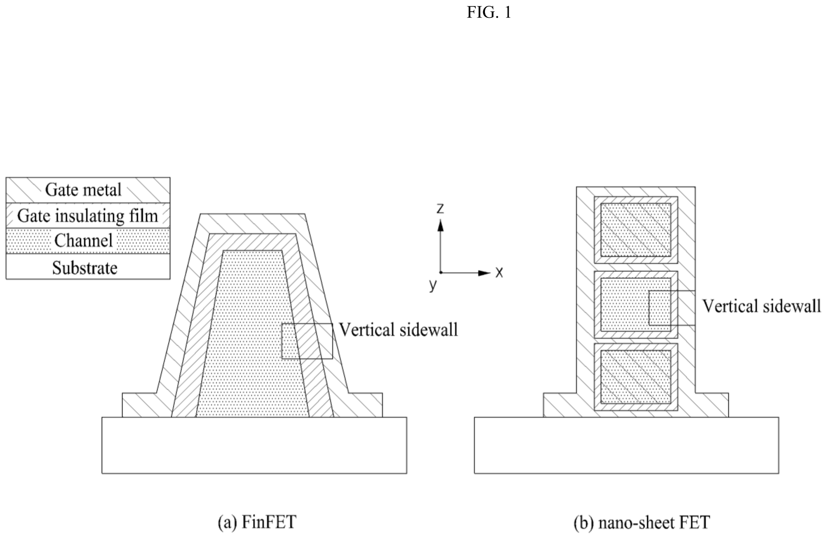

FIG. 1 is a cross-sectional view illustrating a 3D semiconductor gate stack structure to which various example embodiments are applied.

Referring to FIG. 1, the 3D semiconductor gate stack structure may include a substrate, a channel, a gate insulating film, and a gate metal, and may be implemented in a structure in which they are stacked. In some example embodiments, although not illustrated, an additional component may be stacked in the substrate, the channel, the gate insulating film, or the gate metal, or between two thereof. For example, the 3D semiconductor gate stack structure may include a FinFET as shown in (a) of FIG. 1, or may include a nano-sheet FET as shown in (b) of FIG. 1. This 3D semiconductor gate stack structure may have a vertical sidewall. The vertical sidewall represents the lateral surface of the 3D semiconductor gate stack structure, and may indicate an area that vertically extends from the channel to the gate metal.

Here, for the 3D semiconductor gate stack structure, three directions, that is, a first direction (x-direction), a second direction(y-direction), and a third direction(z-direction) may be defined. As the first direction, the length of the 3D semiconductor gate stack structure and the vertical sidewall thereof, particularly, an oxide layer of the vertical sidewall, for example, the thickness from the channel to the gate metal may be defined. That is, the first direction may correspond to the horizontal stack direction of the 3D semiconductor gate stack structure, that is, the direction in which the oxide layer of the vertical sidewall is stacked. As the second direction, the width of the 3D semiconductor gate stack structure may be defined. As the third direction, the height of the 3D semiconductor gate stack structure may be defined. That is, the third direction may correspond to the vertical stack direction of the 3D semiconductor gate stack structure.

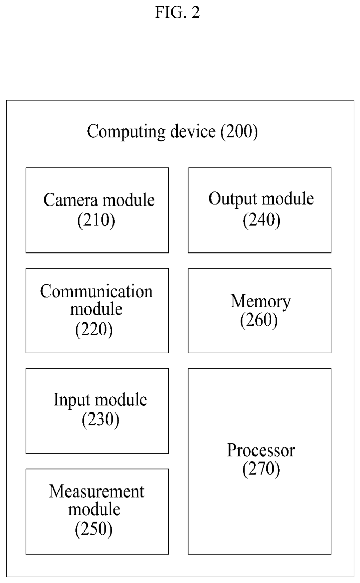

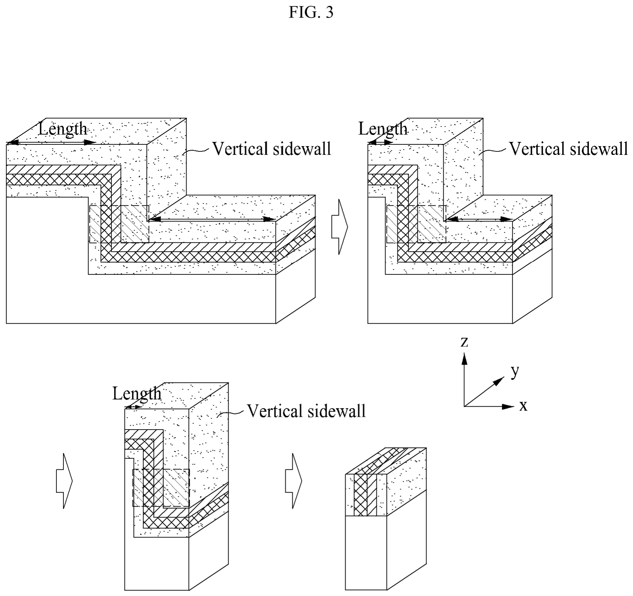

FIG. 2 is a diagram illustrating a computing device 200 according to various example embodiments. FIG. 3 is a drawing for exemplarily explaining operational characteristics of a processor 270 of FIG. 2. Here, in FIG. 3, 3D semiconductor gate stack structures with different areas are illustrated.

Referring to FIG. 2, the computing device 200 relates to evaluating an electrical characteristic of a vertical sidewall in the 3D semiconductor gate stack structure, and may include at least one of a camera module 210, a communication module 220, an input module 230, an output module 240, a measurement module 250, a memory 260, and a processor 270. In some example embodiments, at least one (e.g., camera module 210, communication module 220) of the components of the computing device 200 may be omitted, and at least one another component may be added. In some example embodiments, at least two of the components of the computing device 200 may be implemented as a single integrated circuit. In some example embodiments, the components of the computing device 200 may be provided to at least two devices in a distributed manner. Here, the devices may be communicatively connected to each other.

The camera module 210 may capture an image in the computing device 200. Here, the camera module 210 may be a red, green, blue (RGB) camera, but is not limited thereto. For example, the camera module 210 may include at least one of a lens, an image sensor, an image signal processor, and a flash.

The communication module 220 may communicate with an external device (not shown) in the computing device 200. The communication module 220 may establish a communication channel between the computing device 200 and the external device, and may communicate with the external device through the communication channel. For example, the external device may include at least one of an electronic device, a base station, a server, and a satellite. The communication module 220 may include at least one of a wired communication module and a wireless communication module. For example, the wireless communication module may communicate with the external device through at least one of a far-distance communication network and a near-distance communication network.

The input module 230 may input a command to be used for at least one component of the computing device 200. A user of the input module 230 may include at least one of an input unit configured for the user to directly input a command or data to the computing device 200 and a sensor unit configured to detect an ambient environment and to generate data. For example, the input unit may include at least one of a microphone, a mouse, and a keyboard. In some example embodiments, the input unit may include at least one of a touch circuitry set to detect a touch and a sensor circuitry set to measure intensity of force generated by the touch.

The output module 240 may output information to the outside of the computing device 200. The output module 240 may include at least one of a display module that visually outputs information and an audio module that auditorily outputs information. For example, the display module may include at least one of a display, a holographic device, and a projector. In some example embodiments, the display module may be implemented as a touchscreen by being coupled with at least one of the touch circuitry and the sensor circuitry of the input module 230. For example, the audio module may include at least one of a speaker and a receiver.

The measurement module 250 may measure a 3D semiconductor gate structure. In detail, the measurement module 250 may apply a voltage to a gate electrode of the 3D semiconductor gate structure, and may measure at least one of current-voltage (I-V) characteristic and capacitance-voltage (C-V) characteristic.

The memory 260 may store a variety of data used by at least one component of the computing device 200. For example, the memory 260 may include at least one of a volatile memory and a nonvolatile memory. Data may include input data or output data related to a program or a command related thereto. The program may be stored as software in the memory 260, and may include at least one of an operating system (OS), middleware, and an application.

The processor 270 may control at least one component of the computing device 200 by executing the program of the memory 260. Through this, the processor 270 may perform data processing or operation. Here, the processor 270 may execute the command stored in the memory 260.

In various example embodiments, the processor 270 may evaluate an electrical characteristic of vertical sidewall in the 3D semiconductor gate stack structure. In detail, the processor 270 may analyze electrical characteristics of the entire area of the 3D semiconductor gate stack structure and may isolate only the electrical characteristic of the vertical sidewall through extrapolation. The area may be defined using the first direction and the second direction (e.g., x-direction and y-direction) (i.e., length x width). The vertical sidewall represents the lateral surface of the 3D semiconductor gate stack structure, represents an area that vertically extends from the channel to the gate metal, and a thickness of the vertical sidewall, particularly, an oxide layer of the vertical sidewall may be defined in the first direction. Here, the electrical characteristics may include at least one of leakage current, capacitance, and permittivity.

In more detail, as shown in FIG. 2, the processor 270 may measure, for example, the change in the electrical characteristic according to an area decrease for the 3D semiconductor gate stack structure. In this manner, the processor 270 may extract an electrical characteristic when an area is zero through extrapolation for the 3D semiconductor stack structure and may detect the electrical characteristic of the vertical sidewall therefrom. The processor 270 may derive a slope that represents relationship between areas of the 3D semiconductor gate stack structure and electrical characteristics by extrapolation as shown in [Equation 1] below, and may detect the electrical characteristic of the vertical sidewall by the intercept of the slope as shown in [Equation 2] below.

[Equation 1]

$$m = \frac{n\left(\sum xy\right) - \left(\sum x\right)\left(\sum y\right)}{n\left(\sum x^2\right) - \left(\sum x\right)^2}$$

[Equation 2]

$$y_0 = \frac{\sum y - m\left(\sum x\right)}{n}$$

Here, m denotes the slope, n denotes the number of data points, i.e., the number of areas or electrical characteristics, x denotes an area at each data point, y denotes an electrical characteristic at each data point, and $y_0$ is the y-intercept of the slope and may represent the electrical characteristic of the vertical sidewall.

Therefore, the electrical characteristic of the vertical sidewall may be utilized to optimize a semiconductor device that is implemented in the 3D semiconductor gate stack structure. This may improve the performance and reliability of the semiconductor device.

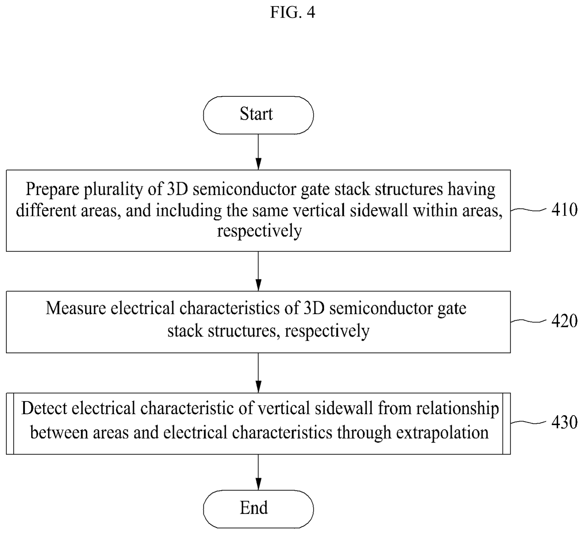

FIG. 4 is a flowchart illustrating an operating method of the computing device 200 according to various example embodiments.

Referring to FIG. 4, in operation 410, a plurality of 3D semiconductor gate stack structures having different areas, and including the same vertical sidewall within the areas, respectively, may be prepared. The area may be defined in directions (e.g., x-direction and y-direction) (i.e., length x width) perpendicular to the stacking direction (e.g., z-direction) (i.e., height) of the 3D semiconductor gate stack structure. The vertical sidewall may be defined in the stacking direction (e.g., z-direction) (i.e., height) of the 3D semiconductor gate stack structure, may represent the lateral surface of the 3D semiconductor gate stack structure, and may represent an area that vertically extends from the channel to the gate metal. Here, the 3D semiconductor gate stack structure of a relatively small area may be identical to a portion of the 3D semiconductor gate stack structure of a relatively large area.

In operation 420, the computing device 200 may measure electrical characteristics of the 3D semiconductor gate stack structures, respectively. In detail, the processor 270 may measure the electrical characteristics of the 3D semiconductor gate stack structures, respectively, through the measurement module 250. Here, the electrical characteristics may include at least one of leakage current, capacitance, and permittivity. In an example embodiment, for each of the 3D semiconductor gate stack structures, in a state in which a source electrode and a drain electrode are coupled, the processor 270 may apply voltage to a gate electrode and may measure a current-voltage (I-V) characteristic and based thereon, may measure leakage current according to the voltage. In another example embodiment, for each of the 3D semiconductor gate stack structures, in a state in which the source electrode and the drain electrode are coupled, the processor 270 may apply the voltage to the gate electrode and may measure a capacitance-voltage (C-V) characteristic and based thereon, may measure capacitance according to the voltage. In another example embodiment, for each of the 3D semiconductor gate stack structures, the processor 270 may derive the permittivity using the measured capacitance. Here, the processor 270 may calculate the permittivity as shown in [Equation 3] below.

[Equation 3]

$$\epsilon = \frac{CA}{t}$$

Here, $\epsilon$ denotes the permittivity, C denotes the capacitance, A denotes the area, and t denotes the thickness of an oxide layer in the vertical sidewall.

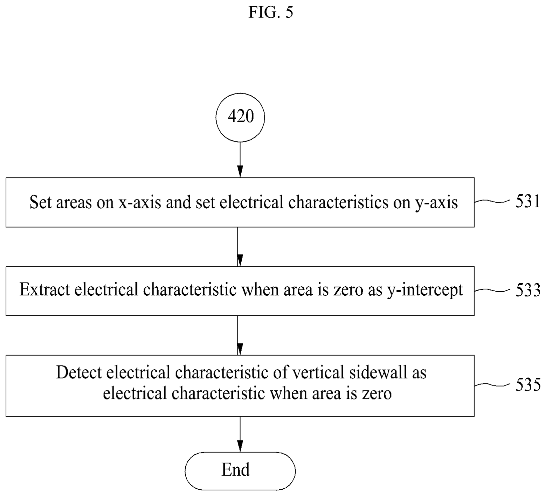

In operation 430, the computing device 200 may detect an electrical characteristic of the vertical sidewall from relationship between the areas and the electrical characteristics of the 3D semiconductor gate stack structures through extrapolation. In detail, the processor 270 may detect the electrical characteristic of the vertical sidewall using the electrical characteristic when the area is zero from the relationship between the areas and the electrical characteristics through extrapolation. Here, the electrical characteristic may include at least one of leakage current, capacitance, and permittivity. In an example embodiment, the processor 270 may detect the leakage current of the vertical sidewall between the areas of the 3D semiconductor gate stack structures and leakage currents. In another example embodiment, the processor 270 may detect the capacitance of the vertical sidewall from the relationship between the areas of the 3D semiconductor gate stack structures and the capacitance. In another example embodiment, the processor 270 may detect the permittivity of the vertical sidewall from the relationship between the areas of the 3D semiconductor gate stack structures and the permittivity. Further description related thereto is made with reference to FIG. 5.

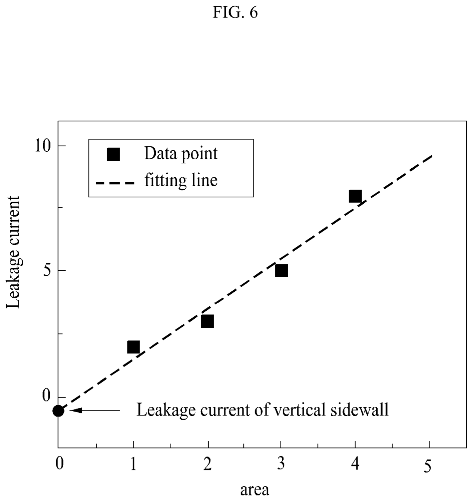

FIG. 5 illustrates operation 430 of detecting the electrical characteristic of the vertical sidewall of FIG. 4. FIG. 6 is a drawing for exemplarily explaining operation 430 of detecting the electrical characteristic of the vertical sidewall of FIG. 4.

Referring to FIGS. 5 and 6, in operation 531, the processor 270 may set the areas and the electrical characteristics of the 3D semiconductor gate stack structures on the x-axis and the y-axis, respectively. In detail, the processor 270 may set the areas to the x-axis, and may set the electrical characteristics to the y-axis. In operation 533, the processor 270 may extract the electrical characteristic when the area is zero as the y-intercept through extrapolation. In detail, the processor 270 may derive the slope representing the relationship between the areas and the electrical characteristics of the 3D semiconductor gate stack structure through extrapolation as shown in [Equation 1] above, and may detect the electrical characteristic of the vertical sidewall as the intercept of the slope, that is, the y-intercept, as shown in [Equation 2] above. In operation 535, the processor 270 may detect the electrical characteristic of the vertical sidewall as the electrical characteristic when the area is zero. Here, although FIG. 6 illustrates an example of detecting the leakage current as the electrical characteristic, but it is not limited thereto. That is, in the same manner as described with reference to FIG. 6, the processor 270 may also detect the capacitance or the permittivity of the vertical sidewall.

Therefore, the electrical characteristic of the vertical sidewall may be utilized to optimize the semiconductor device that is implemented in the 3D semiconductor gate stack structure. This may improve the performance and reliability of the semiconductor device.

According to the present disclosure, for a compact 3D semiconductor gate stack structure, it is possible to precisely detect an electrical characteristic of only a vertical sidewall. Therefore, the electrical characteristic of the vertical sidewall may be utilized for optimization of a semiconductor device that is implemented in the 3D semiconductor gate stack structure. Specifically, it is possible to accurately verify a change in leakage current and effective oxide thickness (EOT) in the vertical sidewall, and to derive an optimal gate insulating film with a stable electrical characteristic. This may present a semiconductor device with improved capacitive effective thickness (CET), and the overall performance and reliability of the semiconductor device may be improved.

In summary, the present disclosure provides an analysis method and device for evaluating an electrical characteristic for a vertical sidewall in a 3D semiconductor gate stack structure.

Herein, an operating method of the computing device 200 may include preparing a plurality of 3D semiconductor gate stack structures having different areas, and including the same vertical sidewall within the areas, respectively (operation 410); measuring electrical characteristics of the 3D semiconductor gate stack structures, respectively (operation 420); and detecting an electrical characteristic of the vertical sidewall from relationship between the areas and the electrical characteristics through extrapolation (operation 430).

Herein, the vertical sidewall represents the lateral surface of the 3D semiconductor gate stack structure, and represents an area that vertically extends from a channel to a gate metal within the 3D semiconductor gate stack structure.

Herein, the electrical characteristics of the 3D semiconductor gate stack structures and the electrical characteristic of the vertical sidewall may include at least one of leakage current, capacitance, and permittivity.

Herein, the detecting the electrical characteristic of the vertical sidewall (operation 430) may include extracting an electrical characteristic when an area is zero from the relationship between the areas and the electrical characteristics through the extrapolation (operation 531 and 533); and detecting the electrical characteristic of the vertical sidewall using the electrical characteristic when the area is zero (operation 535).

Herein, the extracting the electrical characteristic when the area is zero (operations 531 and 533) may include setting the areas on the x-axis and setting the electrical characteristics on the y-axis (operation 531); and extracting the electrical characteristic when the area is zero as the y-intercept (operation 533).

Herein, the measuring the electrical characteristics of the 3D semiconductor gate stack structures, respectively, (operation 420) may include at least one of measuring at least one of leakage current and capacitance for each of the 3D semiconductor gate stack structures; and deriving permittivity using capacitance measured for each of the 3D semiconductor gate stack structures.

Herein, the computing device 200 may include the memory 260, and the processor 270 configured to connect to the memory 260, and to execute at least one instruction stored in the memory 260. The processor 270 may be configured to prepare a plurality of 3D semiconductor gate stack structures having different areas, and including the same vertical sidewall within the areas, respectively, to measure electrical characteristics of the 3D semiconductor gate stack structures, respectively, and to detect an electrical characteristic of the vertical sidewall from relationship between the areas and the electrical characteristics through extrapolation.

Herein, the vertical sidewall represents the lateral surface of the 3D semiconductor gate stack structure, and represents an area that vertically extends from a channel to a gate metal within the 3D semiconductor gate stack structure.

Herein, the electrical characteristics of the 3D semiconductor gate stack structures and the electrical characteristic of the vertical sidewall may include at least one of leakage current, capacitance, and permittivity.

Herein, the processor 270 may be configured to extract an electrical characteristic when an area is zero from the relationship between the areas and the electrical characteristics through the extrapolation, and to detect the electrical characteristic of the vertical sidewall using the electrical characteristic when the area is zero.

The apparatuses described herein may be implemented using hardware components, software components, and/or combination of the hardware components and the software components. For example, the apparatuses and the components described herein may be implemented using one or more general-purpose or special purpose computers, for example, a processor, a controller, an arithmetic logic unit (ALU), a digital signal processor, a microcomputer, a field programmable gate array (FPGA), a programmable logic unit (PLU), a microprocessor, or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will be appreciated that the processing device may include multiple processing elements and/or multiple types of processing elements. For example, the processing device may include multiple processors or a processor and a controller. In addition, other processing configurations are possible, such as parallel processors.

The software may include a computer program, a piece of code, an instruction, or some combinations thereof, for independently or collectively instructing or configuring the processing device to operate as desired. Software and/or data may be embodied in any type of machine, component, physical equipment, computer storage medium or device, to provide instructions or data to the processing device or be interpreted by the processing device. The software also may be distributed over network coupled computer systems so that the software is stored and executed in a distributed fashion. The software and data may be stored by one or more computer readable storage mediums.

The methods according to various example embodiments may be implemented in a form of a program instruction executable through various computer methods and recorded in computer-readable media. Here, the media may be to continuously store a computer-executable program or to temporarily store the same for execution or download. The media may be various types of recording methods or storage methods in which a single piece of hardware or a plurality of pieces of hardware are combined, and may be distributed over a network without being limited to a medium that is directly connected to a computer system. Examples of the media include magnetic media such as hard disks, floppy disks, and magnetic tapes; optical media such as CD ROM and DVD; magneto-optical media such as floptical disks; and hardware devices that are specially configured to store and perform program instructions, such as read-only memory (ROM), random access memory (RAM), flash memory, and the like. Examples of other media may include recording media and storage media managed by an app store that distributes applications or a site, a server, and the like that supplies and distributes other various types of software.

Various example embodiments and the terms used herein are not construed to limit description disclosed herein to a specific implementation and should be understood to include various modifications, equivalents, and/or substitutions of a corresponding example embodiment. In the drawings, like reference numerals refer to like components throughout the present specification. The singular forms "a," "an," and "the" are intended to include the plural forms as well, unless the context clearly indicates otherwise. Herein, the expressions, "A or B," "at least one of A and/or B," "A, B, or C," "at least one of A, B, and/or C," and the like may include any possible combinations of listed items. Terms "first," "second," etc., are used to describe corresponding components regardless of order or importance and the terms are simply used to distinguish one component from another component. The components should not be limited by the terms. When a component (e.g., first component) is described to be "(functionally or communicatively) connected to" or "accessed to" another component (e.g., second component), the component may be directly connected to the other component or may be connected through still another component (e.g., third component).

According to various example embodiments, each of the components (e.g., module or program) may include a singular object or a plurality of objects. According to various example embodiments, at least one of the components or operations may be omitted. Alternatively, at least one another component or operation may be added. Alternatively or additionally, a plurality of components (e.g., modules or programs) may be integrated into a single component. In this case, the integrated component may perform one or more functions of each of the components in the same or similar manner as it is performed by a corresponding component before integration. According to various example embodiments, operations performed by a module, a program, or another component may be performed in a sequential, parallel, iterative, or heuristic manner. Alternatively, at least one of the operations may be performed in different sequence or omitted. Alternatively, at least one another operation may be added.

**Claims**

1. An operating method of a computing device, the method comprising:

   preparing a plurality of three-dimensional (3D) semiconductor gate stack structures having different areas, and including the same vertical sidewall within the areas, respectively;
   measuring electrical characteristics of the 3D semiconductor gate stack structures, respectively; and
   detecting an electrical characteristic of the vertical sidewall from relationship between the areas and the electrical characteristics through extrapolation.

2. The method of claim 1, wherein the vertical sidewall represents the lateral surface of the 3D semiconductor gate stack structure, and represents an area that vertically extends from a channel to a gate metal within the 3D semiconductor gate stack structure.

3. The method of claim 1, wherein the electrical characteristics of the 3D semiconductor gate stack structures and the electrical characteristic of the vertical sidewall include at least one of leakage current, capacitance, and permittivity.

4. The method of claim 1, wherein the detecting the electrical characteristic of the vertical sidewall comprises:

   extracting an electrical characteristic when an area is zero from the relationship between the areas and the electrical characteristics through the extrapolation; and
   detecting the electrical characteristic of the vertical sidewall using the electrical characteristic when the area is zero.

5. The method of claim 4, wherein the extracting the electrical characteristic when the area is zero comprises:

   setting the areas on the x-axis and setting the electrical characteristics on the y-axis; and
   extracting the electrical characteristic when the area is zero as the y-intercept.

6. The method of claim 3, wherein the measuring the electrical characteristics of the 3D semiconductor gate stack structures, respectively, comprises at least one of:

   measuring at least one of leakage current and capacitance for each of the 3D semiconductor gate stack structures; and
   deriving permittivity using capacitance measured for each of the 3D semiconductor gate stack structures.

7. A computing device comprising:

   a memory; and
   a processor configured to connect to the memory, and to execute at least one instruction stored in the memory, wherein the processor is configured to,
   prepare a plurality of three-dimensional (3D) semiconductor gate stack structures having different areas, and including the same vertical sidewall within the areas, respectively,
   measure electrical characteristics of the 3D semiconductor gate stack structures, respectively, and
   detect an electrical characteristic of the vertical sidewall from relationship between the areas and the electrical characteristics through extrapolation.

8. The computing device of claim 7, wherein the vertical sidewall represents the lateral surface of the 3D semiconductor gate stack structure, and represents an area that vertically extends from a channel to a gate metal within the 3D semiconductor gate stack structure.

9. The computing device of claim 7, wherein the electrical characteristics of the 3D semiconductor gate stack structures and the electrical characteristic of the vertical sidewall include at least one of leakage current, capacitance, and permittivity.

10. The computing device of claim 7, wherein the processor is configured to,

    extract an electrical characteristic when an area is zero from the relationship between the areas and the electrical characteristics through the extrapolation, and
    detect the electrical characteristic of the vertical sidewall using the electrical characteristic when the area is zero.

FIG. 1

| Gate metal |
| Gate insulating film |
| Channel |
| Substrate |

Vertical sidewall

(a) FinFET

Vertical sidewall

(b) nano-sheet FET

EP 4 764 516 A1

FIG. 2

Computing device (200)

Camera module
(210)

Output module
(240)

Communication
module
(220)

Memory
(260)

Input module
(230)

Measurement
module
(250)

Processor
(270)

FIG. 3

Length

Vertical sidewall

Length

Vertical sidewall

z

y

x

Length

Vertical sidewall

FIG. 4

```
                        ┌──────────────┐
                        │    Start     │
                        └──────┬───────┘
                               │
                               ▼
┌─────────────────────────────────────────────────────────────┐
│  Prepare plurality of 3D semiconductor gate stack structures  │
│  having different areas, and including the same vertical      │──  410
│  sidewall within areas, respectively                          │
└──────────────────────────────┬────────────────────────────────┘
                               │
                               ▼
┌─────────────────────────────────────────────────────────────┐
│  Measure electrical characteristics of 3D semiconductor gate  │──  420
│  stack structures, respectively                               │
└──────────────────────────────┬────────────────────────────────┘
                               │
                               ▼
┌─────────────────────────────────────────────────────────────┐
│  Detect electrical characteristic of vertical sidewall from   │──  430
│  relationship between areas and electrical characteristics    │
│  through extrapolation                                        │
└──────────────────────────────┬────────────────────────────────┘
                               │
                               ▼
                        ┌──────────────┐
                        │     End      │
                        └──────────────┘
```

FIG. 5

420

Set areas on x-axis and set electrical characteristics on y-axis — 531

Extract electrical characteristic when area is zero as y-intercept — 533

Detect electrical characteristic of vertical sidewall as electrical characteristic when area is zero — 535

End

FIG. 6

Europäisches
Patentamt
European
Patent Office
Office européen
des brevets

## EUROPEAN SEARCH REPORT

**Application Number**

EP 25 20 6404

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2017/242065 A1 (GUO JYH-CHYURN [TW] ET AL) 24 August 2017 (2017-08-24)<br>* figures *<br>* claims *<br>* paragraphs [0017] - [0037] *<br>----- | 1-10 | INV.<br>G01R31/26 |
| A | CN 100 481 361 C (SEMICONDUCTOR ENERGY LAB [JP]) 22 April 2009 (2009-04-22)<br>* the whole document *<br>----- | 1-10 | |

**TECHNICAL FIELDS
SEARCHED (IPC)**

G01R

The present search report has been drawn up for all claims

| Place of search | Date of completion of the search | Examiner |
|---|---|---|
| Munich | 30 March 2026 | Moulara, Guilhem |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 6404

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2026

| Patent document cited in search report | Publication date | Patent family member(s) | Publication date |
|---|---|---|---|
| US 2017242065 A1 | 24-08-2017 | TW 201730792 A | 01-09-2017 |
| | | US 2017242065 A1 | 24-08-2017 |
| CN 100481361 C | 22-04-2009 | CN 1580798 A | 16-02-2005 |
| | | JP 4364577 B2 | 18-11-2009 |
| | | JP 2005049299 A | 24-02-2005 |
| | | KR 20050014677 A | 07-02-2005 |
| | | TW I333075 B | 11-11-2010 |
| | | US 2005024079 A1 | 03-02-2005 |

EPO FORM P0459